# EUROPEAN PATENT APPLICATION

(11) **EP 4 727 293 A1**
(43) Date of publication of application: **15.04.2026**
(21) Application number: 25205563.7
(22) Date of filing: 30.09.2025
(51) Int. Cl.: H10D 84/85, H10D 30/01, H10D 30/00, H10D 88/00

(54) **INTEGRATED CIRCUIT DEVICES AND METHODS OF FORMING THE SAME**

(30) Priority: 08.10.2024 US 202463704658 P; 27.03.2025 US 202519092421
(71) Applicant: Samsung Electronics Co., Ltd., Suwon-si, Gyeonggi-do 16677 (KR)
(72) Inventor: CHO, Edward Namkyu, San Jose, CA, 95134 (US); PARK, Kibyung, San Jose, CA, 95134 (US); PARK, Beomjin, San Jose, CA, 95134 (US); JANG, Sangshin, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

An integrated circuit device includes a transistor structure having one or more channel patterns (104) that extend between source/drain regions (108) in a first direction (D1) and are alternately stacked with one or more gate patterns (102). Hollow inner spacers (110) are provided between the one or more gate patterns (102) and the source/drain regions (108). The hollow inner spacers (110) include respective voids (114) between side surfaces of the one or more gate patterns (102) and first side surfaces of the source/drain regions (108) in the first direction (D1), and a first liner (111) on the side surfaces of the one or more gate patterns (102) and on the first side surfaces of the source/drain regions (108). Related fabrication methods are also discussed.

## Description

### TECHNICAL FIELD

The present disclosure relates to integrated circuit devices.

### BACKGROUND

The size of transistors in integrated circuit devices has continued to decrease in order to maintain downscaling of logic elements. Technology to increase transistor density and concentrate more transistors within the same area has continued to develop. As such, three-dimensional (3D) device structures are under consideration, and 3D stacking processes have been proposed.

One type of 3D device structure is a stacked transistor. Integrated circuit devices may utilize stacked transistors to increase density and improve performance. In some instances, the stacked transistors may be complementary to each other (e.g., complementary metal-oxide-semiconductor (CMOS) transistors). For example, a Complementary-FET (CFET) layout may include multiple vertically stacked pairs of gate-all-around field effect transistors (GAAFETs), with P-type GAAFETs on one-level, N-type GAAFETs on another level (i.e., above or below), and shared gates, where each shared gate extends between and wraps around the channel patterns of the stacked pair of N-type and P-type GAAFETs. In such structures, the source/drain regions of the lower GAAFET are electrically isolated from the source/drain regions of the upper GAAFET by dielectric layers.

Parasitic capacitance is a phenomenon that can occur in integrated circuit devices where unintended capacitance exists between components. Parasitic capacitance may arise due to the proximity of conductive components and can negatively affect device performance by increasing power consumption, compromising signal integrity, and the like.

### SUMMARY

According to some embodiments, an integrated circuit device includes a transistor structure comprising one or more channel patterns that extend between source/drain regions in a first direction and are alternately stacked with one or more gate patterns, and hollow inner spacers between the one or more gate patterns and the source/drain regions. The hollow inner spacers comprise respective voids between side surfaces of the one or more gate patterns and first side surfaces of the source/drain regions in the first direction, and a first liner on the side surfaces of the one or more gate patterns and on the first side surfaces of the source/drain regions.

In some embodiments, the first liner conformally extends on the side surfaces of the one or more gate patterns and the first side surfaces of the source/drain regions, and the respective voids are bounded by the first liner in the first direction.

In some embodiments, the hollow inner spacers further include a second liner on second side surfaces of the source/drain regions, which oppose one another in a second direction that intersects the first direction, wherein the second liner and the first liner collectively enclose the respective voids.

In some embodiments, the second liner non-conformally extends on the second side surfaces of the source/drain regions, and the respective voids are bounded by the second liner in the second direction.

In some embodiments, the second liner extends at least partially between respective portions of the first liner on the side surfaces of the gate patterns and the first side surfaces of the source/drain regions.

In some embodiments, the hollow inner spacers have a first thickness with the respective voids therebetween in a first cross-section along the first direction, and have a second thickness that is free of the respective voids therebetween in a second cross-section along the first direction.

In some embodiments, the first liner and/or the second liner comprise respective materials having a dielectric constant that is less than or equal to that of silicon nitride.

In some embodiments, the transistor structure comprises a stacked transistor structure on a substrate, the stacked transistor structure comprising a first transistor between the substrate and a second transistor stacked thereon.

In some embodiments, the one or more channel patterns comprise lower and upper nanosheets of first and second transistors, respectively; the one or more gate patterns comprise lower gate and upper gate patterns of the first and second transistors, respectively; and the source/drain regions comprise lower and upper source/drain regions of the first and second transistors, respectively.

In some embodiments, the lower source/drain regions are of a first conductivity type, and the upper source/drain regions are of a second conductivity type that is opposite to the first conductivity type.

According to some embodiments, a method of fabricating an integrated circuit device includes forming a plurality of channel patterns and sacrificial gate patterns that extend in a first direction and are alternately stacked on a substrate. The sacrificial gate patterns are selectively recessed at their opposing ends in the first direction to expose their side surfaces. Preliminary inner spacers are formed on the exposed side surfaces, and source/drain regions are formed at opposing ends of the channel patterns such that the preliminary inner spacers are positioned between the side surfaces of the sacrificial gate patterns and the first side surfaces of the source/drain regions, which face one another in the first direction. An etching process is subsequently performed to remove the preliminary inner spacers, and a first liner is formed on the side surfaces of the sacrificial gate patterns as well as on the first side surfaces of the source/drain regions, thereby providing respective voids between the side surfaces of the sacrificial gate patterns and the first side surfaces of the source/drain regions in the first direction.

In some embodiments, the first liner is formed in a conformal manner on the side surfaces of the sacrificial gate patterns and the first side surfaces of the source/drain regions, such that that the respective voids are bounded by the first liner in the first direction.

In some embodiments, a second liner is formed on the second side surfaces of the source/drain regions, which oppose one another in a second direction that intersects the first direction. The second liner, together with the first liner, collectively form hollow inner spacers that enclose the respective voids.

In some embodiments, the second liner is deposited non-conformally on the second side surfaces of the source/drain regions, such that the respective voids are bounded by the second liner in the second direction.

In some embodiments, the second liner extends at least partially between portions of the first liner located on the side surfaces of the sacrificial gate patterns and the first side surfaces of the source/drain regions.

In some embodiments, the hollow inner spacers have a first thickness that includes the respective voids in a first cross-section along the first direction and a second thickness that is free of the respective voids in a second cross-section along the first direction.

In some embodiments, the first liner and/or the second liner comprise materials having a dielectric constant that is less than or equal to that of silicon nitride.

In some embodiments, after forming the liners, the sacrificial gate patterns between the respective voids are removed, and gate patterns are formed to replace the sacrificial gate patterns. The first insulating patterns extend along side surfaces of the gate patterns and along the first side surfaces of the source/drain regions, with the respective voids therebetween.

According to some embodiments, a method of fabricating an integrated circuit device includes forming channel patterns that extend between source/drain regions in a first direction and are alternately stacked with sacrificial gate patterns. Hollow inner spacers are formed between the sacrificial gate patterns and the source/drain regions by forming a first liner that conformally extends on side surfaces of the sacrificial gate patterns and first side surfaces of the source/drain regions, thereby providing voids therebetween in the first direction, and forming a second liner that non-conformally extends on the second side surfaces of the source/drain regions, which oppose one another in a second direction intersecting the first direction. The respective voids are bounded by the first liner in the first direction and by the second liner in the second direction.

In some embodiments, the second liner extends at least partially between the portions of the first liner on the side surfaces of the sacrificial gate patterns and the first side surfaces of the source/drain regions, collectively enclosing the respective voids.

In some embodiments, the hollow inner spacers have a first thickness that with the respective voids therebetween in a first cross-section along the first direction, and a second thickness that is free of the respective voids in a second cross-section along the first direction.

In some embodiments, prior to forming the hollow inner spacers, the sacrificial gate patterns are selectively recessed at opposing ends thereof in the first direction to expose side surfaces thereof. Preliminary inner spacers are formed on the side surfaces of the sacrificial gate patterns, and source/drain regions are formed at the opposing ends of the channel patterns such that the preliminary inner spacers reside between the side surfaces of the sacrificial gate patterns and the first side surfaces of the source/drain regions that face one another in the first direction. An etching process is performed to remove the preliminary inner spacers between the sacrificial gate patterns and the source/drain regions.

Other devices, apparatus, and/or methods according to some embodiments will become apparent to one with skill in the art upon review of the following drawings and detailed description. It is intended that all such additional embodiments, in addition to any and all combinations of the above embodiments, be included within this description, be within the scope of the invention, and be protected by the accompanying claims.

### BRIEF DESCRIPTION OF THE DRAWINGS

FIG. 1 is a plan or layout view illustrating a semiconductor integrated circuit device according to some embodiments.
FIG. 2A is an enlarged cross-sectional view of a transistor structure TS of FIG. 1, illustrating a transistor unit cell including a gate pattern between source/drain regions of a semiconductor integrated circuit device according to some embodiments of the present disclosure.
FIGS. 2B and 2C are cross-sectional views taken along lines X1-X1 and X2-X2 of FIG. 2A, respectively, illustrating an example configuration of a semiconductor integrated circuit device according to some embodiments of the present disclosure.
FIGS. 3, 4, 5, 6, 7, 8, 9, and 10 are schematic cross-sectional views illustrating methods of fabricating semiconductor integrated circuit devices according to some embodiments of the present disclosure.
FIGS. 11A, 12A, and 13A are schematic cross-sectional views illustrating methods of fabricating semiconductor integrated circuit devices according to some embodiments of the present disclosure.
FIGS. 11B, 12B, and 13B correspond to FIG. 2A.
FIGS. 14A, 14B, 15A, and 15B are schematic cross-sectional views illustrating methods of fabricating semiconductor integrated circuit devices according to some embodiments of the present disclosure.
FIGS. 14C and 15C correspond to FIG. 2A.
FIGS. 16 and 17 are flowcharts illustrating methods of fabricating semiconductor integrated circuit devices according to some embodiments of the present disclosure.

### DETAILED DESCRIPTION OF EMBODIMENTS

In embodiments described herein, a stacked transistor structure may include a first transistor and a second transistor. The first transistor may be a first type of transistor (e.g., an n-type field-effect transistor (nFET), such as an n-type metal-oxide-semiconductor (NMOS) transistor), and the second transistor may be a second type of transistor (e.g., a p-type field-effect transistor (pFET), such as a p-type metal-oxide-semiconductor (PMOS) transistor). The first and second transistors may be stacked in any order (e.g., first on top of second, or second on top of first), resulting in a stacked structure (e.g., a stacked FET structure such as a 3D stacked FET (3DSFET)) including a top device (also referred to herein as an upper device or upper transistor, relative to an underlying substrate) and a bottom device (also referred to herein as a lower device or lower transistor, relative to the underlying substrate). In some stacked transistors, nanosheets or nanowires may be vertically stacked and at least partially surrounded by a gate to improve channel control.

Some embodiments of the present disclosure may arise from realization that the presence of inner spacers adjacent the source/drain regions in a semiconductor device (e.g., a 3DSFET) may help reduce parasitic capacitance. For example, the inner spacers may be between a gate structure and the source/drain regions.

Embodiments of the present disclosure are directed to methods of forming air pockets within the inner spacers that are provided between the source/drain regions and the gates of an integrated circuit device, such as a 3DSFET. As used herein, an air pocket or air gap may also be referred to as a cavity or void, and may include gases other than (or in different ratios than) those included in air (e.g., other than oxygen and nitrogen). Inner spacers as described herein may thereby reduce parasitic capacitance by enclosing air therewithin, as air has a lower dielectric constant than silicon oxide or other dielectric materials typically used in semiconductor fabrication. Accordingly, example embodiments of the present disclosure may provide an integrated circuit device (e.g., a 3DSFET) having inner spacers that include air pockets or air gaps, also referred to as hollow inner spacers.

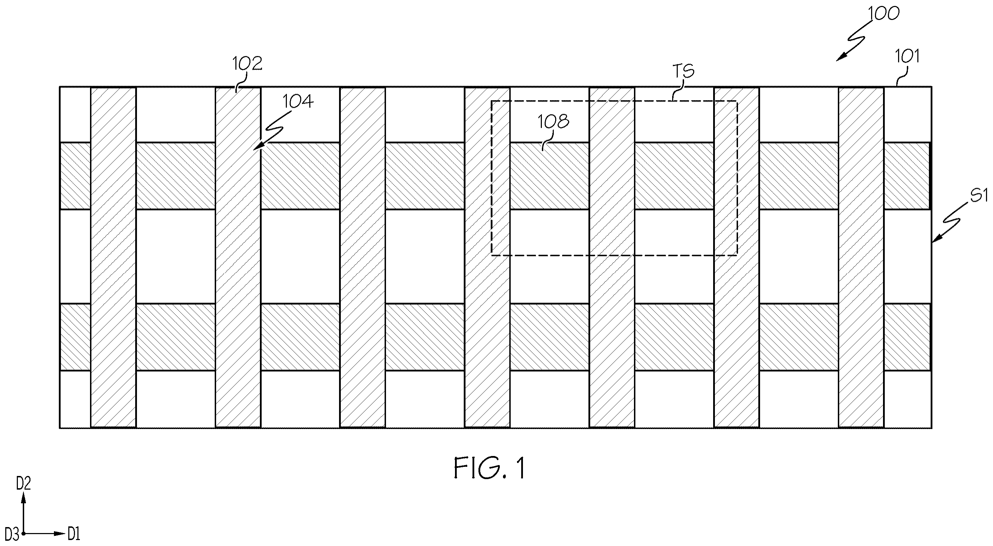

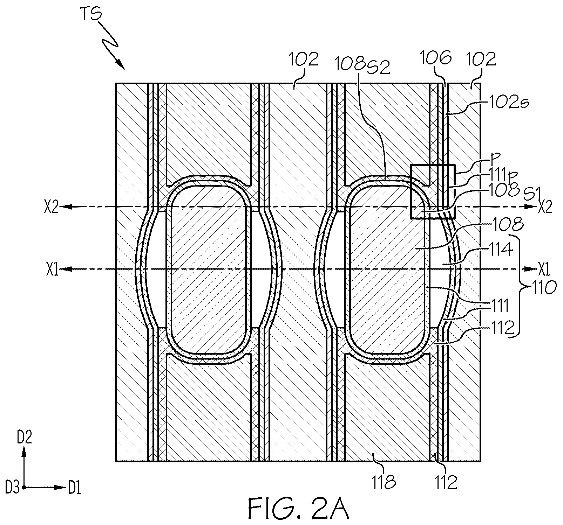

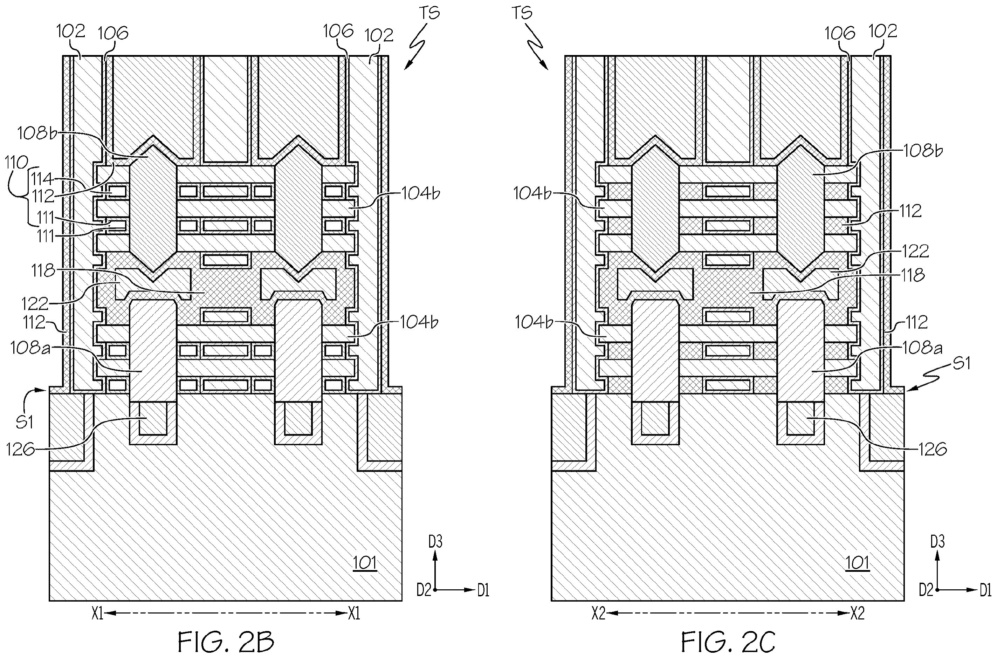

FIG. 1 is a plan or layout view illustrating an integrated circuit device 100 according to some embodiments of the present disclosure. FIG. 2A is an enlarged cross-sectional view of a transistor structure TS of FIG. 1, illustrating a transistor unit cell including a gate pattern between source/drain regions. FIGS. 2B and 2C are cross-sectional views taken along lines X1-X1 and X2-X2 of FIG. 2A, respectively.

Referring to FIGS. 1 and 2A-2C, the integrated circuit device 100 may include a substrate 101 (also referred to as a backside insulating layer) and a plurality of transistor structures TS (also referred to as transistors) on a first side (or frontside) S1 of the substrate 101. The substrate 101 may extend in a first direction D1 (also referred to as a first horizontal direction or X direction) and a second direction D2 (also referred to as a second horizontal direction or Y direction) that intersects the first direction D1. The first direction D1 and the second direction D2 may be parallel to a surface (e.g., the frontside S1) of the substrate 101. In some embodiments, the first direction D1 may be perpendicular to the second direction D2.

In some embodiments, the substrate 101 may include or may be semiconductor material(s), for example, Si, Ge, SiGe, GaP, GaAs, SiC, SiGeC and/or InP. For example, the substrate 101 may be insulating layer(s), a bulk substrate (e.g., a bulk silicon wafer) and/or a semiconductor-on-insulator (SOI) substrate. In some embodiments, the substrate 101 may include or may be formed of insulating material(s), for example, silicon oxide, silicon oxynitride, silicon nitride, silicon carbonitride, silicon boron nitride and/or a low-k dielectric material. The low-k dielectric material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric. A thickness of the substrate 101 in a third direction D3 (also referred to as a vertical direction or Z direction) may be, for example, in a range of (about) 50 nm to 100 nm. In some embodiments, the third direction D3 may be perpendicular to the first direction D1 and/or the second direction D2. The third direction D3 may be perpendicular to the surface (e.g., the frontside S1) of the substrate 101.

Each of the transistor structures TS may include a gate structure including gate patterns 102 and a channel structure including channel patterns 104 that extend between source/drain regions 108 (in the first direction D1). The gate patterns 102 may overlap the channel patterns 104 in the third direction D3. The channel patterns 104 may extend in the first direction D1 between the source/drain regions 108, and the gate patterns 102 may extend in the second direction D2. In some embodiments, each of the transistor structures TS may include multiple channel patterns 104 stacked in the third direction D3, and the channel patterns 104 may be spaced apart from each other in the third direction D3. For example, the transistor structures TS may be nanosheet transistors that include a stack of nanosheet layers provided by the channel patterns 104.

Each of the transistor structures TS may also include a pair of source/drain regions 108 that are spaced apart from each other in the first direction D1. The source/drain regions 108 may include a semiconductor layer (e.g., a silicon (Si) layer and/or a silicon germanium (SiGe) layer) and may additionally include dopants in the semiconductor layer. The gate patterns 102 may be provided between the pair of source/drain regions 108. The source/drain regions 108 may contact opposing side surfaces of the channel patterns 104 that are spaced apart from each other in the first direction D1. The transistor structure TS may further include hollow inner spacers 110 between the gate patterns 102 and the source/drain region 108 (in the first direction D1), as described in greater detail below.

The channel patterns 104 may include semiconductor material(s) (e.g., Si, Ge, SiGe, GaP, GaAs, SiC, SiGeC and/or InP). In some embodiments, the channel patterns 104 may include nanosheets that may have a thickness, for example, in a range from (about) 1 nanometer (nm) to 100 nm in the third direction D3, or may be nanowires having a circular cross-section with a diameter, for example, in a range of from (about) 1 nm to 100 nm. When the channel patterns 104 include a nanosheet or nanowire, the gate patterns 102 may extend around (e.g. to at least partially surround) the channel patterns 104 on multiple sides.

The integrated circuit device 100 may include multiple gate patterns 102 that extend (i.e., longitudinally) in the second direction D2 and are spaced apart from each other in the first direction D1. Each of the gate patterns 102 may include a single layer or multiple layers. In some embodiments, each of the gate patterns 102 may include a metal layer or material that includes, for example, tungsten (W), aluminum (Al), copper (Cu), molybdenum (Mo), cobalt (Co) and/or ruthenium (Ru), and may additionally include work function layer(s) (e.g., a TiN layer, a TaN layer, a TiAl layer, a TiC layer, a TiAlC layer, a TiAlN layer and/or a WN layer). In some embodiments, each of the gate patterns 102 may include the same material(s).

A gate insulating layer 106 (also referred to as a gate insulator) may extend between the gate patterns 102 and the channel patterns 104. More particularly, the gate insulator 106 may contact and physically separate the gate patterns 102 and the channel patterns 104 (including nanosheets thereof). The gate insulator 106 may include a single layer or multiple layers (e.g., a silicon oxide layer and/or a high-k dielectric material layer). For example, the high-k dielectric material layer may include Al₂O₃, HfO₂, ZrO₂, HfZrO₄, TiO₂, Sc₂O₃, Y₂O₃, La₂O₃, Lu₂O₃, Nb₂O₅ and/or Ta₂O₅.

In some embodiments, the transistor structure TS may be a three-dimensional (3D) field effect transistor (FET) such as a multi-bridge channel FET (MBCFET). In some embodiments, the transistor structure TS may have a structure different from that illustrated. For example, the transistor structure TS may be a gate-all-around FET (GAAFET) including a single channel structure or a fin-shaped FET (FinFET).

As shown in FIGS. 2A, 2B, and 2C, the integrated circuit device 100 includes a stacked transistor structure TS including first and second transistors 202a, 202b vertically stacked (in the direction D3) on the substrate 101. The first transistor 202a includes at least one first or lower channel pattern 104a between gate patterns 102. The second transistor 202b includes at least one second or upper channel pattern 104b between gate patterns 102. In the example of FIGS. 2A to 2C, multiple upper channel patterns 104b are stacked on multiple lower channel patterns 104a, with the gate patterns 102 alternatingly stacked between the channel patterns 104a, 104b, but embodiments of the present disclosure may include fewer or more channel patterns than shown. In some embodiments, the channel patterns 104 may include lower channel patterns 104a (for example, lower nanosheets) and upper channel patterns 104b (for example, upper nanosheets) of the first transistor 202a and second transistor 202b, respectively, while the gate patterns 102 may include lower gate patterns 102a and upper gate patterns 102b of the first transistor 202a and second transistor 202b, respectively. The channel patterns 104 may be provided by semiconductor materials, such as silicon (Si).

The source/drain regions 108 may include lower source/drain regions 108a and upper source/drain regions 108b of the first transistor 202a and second transistor 202b, respectively. The lower source/drain regions 108a of the first transistor 202a are provided on opposing sides (also referred to herein as opposing ends) of the lower channel patterns 104a, and upper source/drain regions 108b of the second transistor 202b are provided on opposing sides or ends of the upper channel patterns 104b. In some embodiments, the lower source/drain regions 108a may include a same material or material composition as the lower channel patterns 104a and the substrate 101. For example, the lower channel patterns 104a and the lower source/drain regions 108a may be implemented as silicon layers. In some embodiments, the upper source/drain regions 108b may include a different material or material composition than the lower source/drain regions 108a. For example, the upper source/drain regions 108b may be implemented as silicon germanium (SiGe) layers, while the lower source/drain regions 108a may be implemented as silicon (Si) layers.

Isolation patterns 118 and 122 provide electrical isolation between the first and second transistors 202a and 202b. In particular, isolation patterns 122 are provided between the lower surfaces of the upper source/drain regions 108b and upper surfaces of the lower source/drain regions 108a (as well as between gate patterns 102), while isolation patterns 118 (also referred to as a middle dielectric isolation (MDI) are provided between lower gate patterns 102a of the first transistor 202a and the upper gate patterns 102b of the second transistor 202b. Gate insulating layers 106 (e.g., gate oxide patterns) may extend around the gate patterns 102 and between the gate patterns 102 and the channel patterns 104. The gate insulating layers 106 may be also provided between the gate patterns 102.

In some embodiments, the first (lower) transistors 202a and second (upper) transistors 202b may have complementary conductivity types, e.g., to provide a CMOS device. In particular, the first transistors 202a may have a first conductivity type (e.g., n-type), while the second transistors 202b may have a second conductivity type (e.g., p-type) that is opposite to the first conductivity type, or vice versa. That is, stacked transistor structures TS according to embodiments of the present disclosure are not limited to particular orientations of transistors having the different conductivity types. Moreover, the first and second transistors 202a and 202b may have the same conductivity type (e.g., both the first and second transistors 202a and 202b may be n-type, or both the first and second transistors 202a and 202b may be p-type) in some embodiments. Also, while illustrated with reference to first and second transistors 202a and 202b, it will be understood that stacked transistor structures TS according to embodiments of the present disclosure are not limited to two-transistor arrangement, and may include additional transistors (e.g., third transistors, fourth transistors, etc.) that are vertically stacked on the substrate 101.

The stacked transistor structures TS thus include channel patterns 104 that extend between source/drain regions 108 in a first direction D1 and gate patterns 102 that extend in a second direction D2, where the channel patterns 104 and the gate patterns 102 are alternately stacked in the third direction D3. The stacked transistor structure TS further includes hollow inner spacers 110 that provide voids 114 between the gate patterns 102 and the source/drain regions 108, in particular, between side surfaces 102s of the gate patterns 102 and first side surfaces 108s1 of the source/drain regions 108 in the first direction D1. As noted above, the voids 114 may be implemented by air pockets or air gaps between portions of or enclosed within the hollow inner spacers 110.

As shown in FIGS. 2A, 2B, and 2C, the hollow inner spacers 110 include a first insulating liner (generally referred to herein as a first liner) 111 on the side surfaces 102s of the gate patterns 102 and on the first side surfaces 108s1 of the source/drain regions 108, with the respective voids 114 therebetween. More particularly, the first insulating liner 111 conformally extends on the side surfaces 102s of the gate patterns 102 and the first side surfaces 108s1 of the source/drain regions 108, such that the respective voids 114 are bounded by the first insulating liner 111 in the first direction D1. The first insulating liner 111 may be formed of a dielectric material (e.g., silicon nitride (SiN) and/or a low-k material having a dielectric constant lower than that of silicon oxide (SiO)). Further example materials for the first insulating liner 111 may include, but are not limited to, SiOC, SiCN, SiC, SiBCN, and SiOCN. The first insulating liner 111 may be a relatively thin layer. For example, the first insulating liner 111 may be deposited by a chemical vapor deposition (CVD) process, a physical vapor deposition (PVD) process, an atomic layer deposition (ALD) process, or the like, such that the first insulating liner 111 conformally extends on the side surfaces 102s of the gate patterns 102 and the first side surfaces 108s1 of the source/drain regions 108.

The hollow inner spacers 110 further include a second insulating liner (generally referred to herein as a second liner) 112 on second side surfaces 108s2 of the source/drain regions 108, which oppose one another in the second direction D2. The second insulating liner 112 non-conformally extends on the second side surfaces 108s2 of the source/drain regions 108, such that the respective voids 114 are bounded by the second insulating liner 112 in the second direction D2. The second insulating liner 112 may be formed of a dielectric material (e.g., SiN) and/or a low-k material having a dielectric constant lower than that of SiO, for example, using a CVD process, PVD process, ALD process, or the like. Further example materials for the second insulating liner 112 may include, but are not limited to, SiOC, SiCN, SiC, SiBCN, and SiOCN.

As shown in greater detail in FIG. 2A, the second insulating liner 112 may extend at least partially between respective portions 111p of the first insulating liner 111 on the side surfaces 102s of the gate patterns 102 and the first side surfaces 108s1 of the source/drain regions 108. For example, the second insulating liner 112 may be deposited using a liner overhang technique, such that portions P thereof overlap with the portions 111p of the first insulating liner 111 at edges of the hollow inner spacers 110. The second insulating liner 112 may have or may be deposited with a thickness that is greater than the thickness of the first insulating liner 111. Central portions of the hollow inner spacers 110 thus have a first thickness T1 (corresponding to the thickness of the conformal first insulating liner 111) with the respective voids 114 therebetween in a first cross-section X1 along the first direction D1, while edge portions of the hollow inner spacers 110 have a second thickness T2 (corresponding to the combined thickness of the second insulating liner 112 and the first insulating liner 111) that is free of the respective voids 114 therebetween in a second cross-section X2 along the first direction. That is, the hollow inner spacers 110 may have different profiles (hollow vs. filled) depending on whether the cross-sections are taken at central portions (along line X1-X1) or edge portions (along line X2-X2) thereof.

The second insulating liner 112 and the first insulating liner 111 thereby extend both on side surfaces 102s of the gate patterns 102 and on side surfaces 108s1, 108s2 of the source/drain regions 108, so as to collectively enclose the respective voids 114. As noted above, the enclosed voids 114 may have a lower dielectric constant than silicon oxide or other dielectric materials typically used to form inner spacers between gate patterns and source/drain regions, allowing for reduced parasitic capacitance. The first insulating liner 111 and/or the second insulating liner 112 of the hollow inner spacers 110 may be formed of insulating materials that differ from the gate insulating layers 106 in some embodiments.

Although FIGS. 2B and 2C illustrate that the first transistor 202a includes two channel patterns 104a and the second transistor 202b includes three channel patterns 104b, in some embodiments, fewer or more channel layers 104 may be included in each transistor 202a, 202b in accordance with embodiments of the present disclosure. Also, while not shown, the integrated circuit device 100 may also include a middle-of-line (MOL) structure and a back-end-of-line (BEOL) structure. Each of the MOL and BEOL structures may include interlayer insulating layer(s) in which conductive wire(s) (e.g., metal wire(s)) and conductive via plug(s) (e.g., metal via plug(s)) are provided. Various elements of the first transistor 202a and/or the second transistor 202b may be electrically connected to one or more of the conductive wires of the MOL and BEOL structures.

Further, in some embodiments, a backside power distribution network structure (BSPDNS) and associated conductive structures may be provided below or within the substrate 101. The BSPDNS may include backside insulating layer(s) in which conductive backside wire(s) (e.g., metal power rail(s)) and conductive backside contact(s) (e.g., backside metal contact(s)) are provided. Various elements of the first transistor 202a and/or the second transistor 202b may be electrically connected to one of the conductive backside wires.

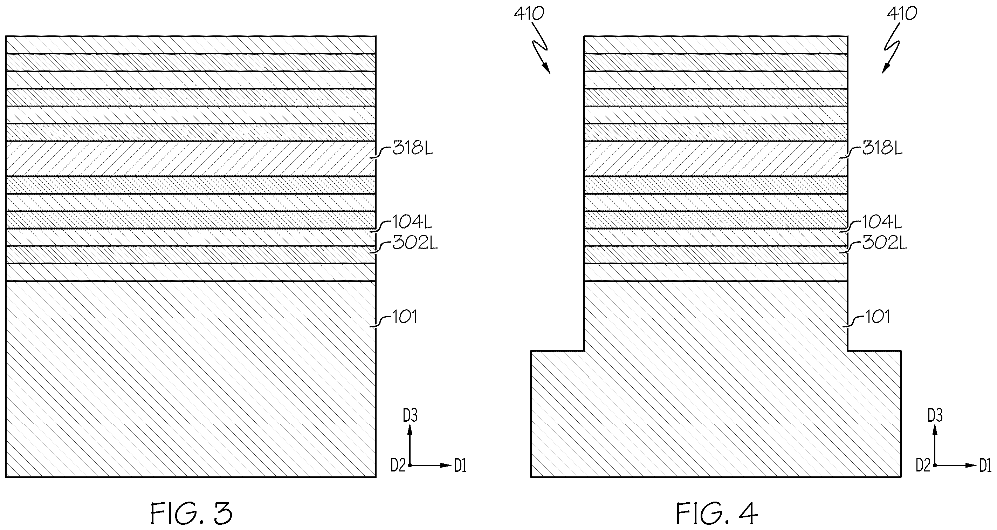

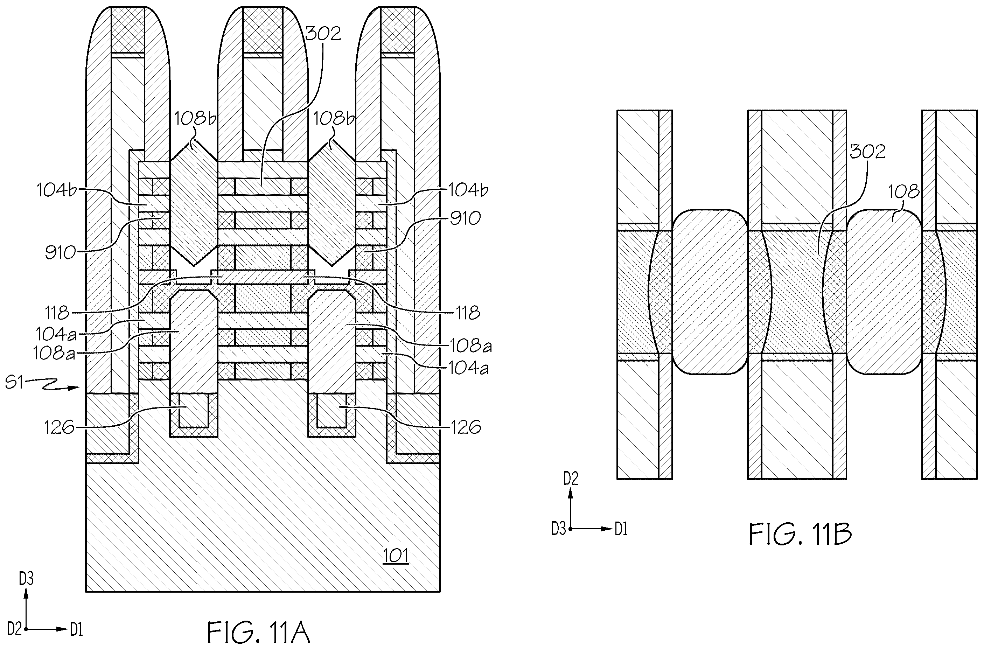

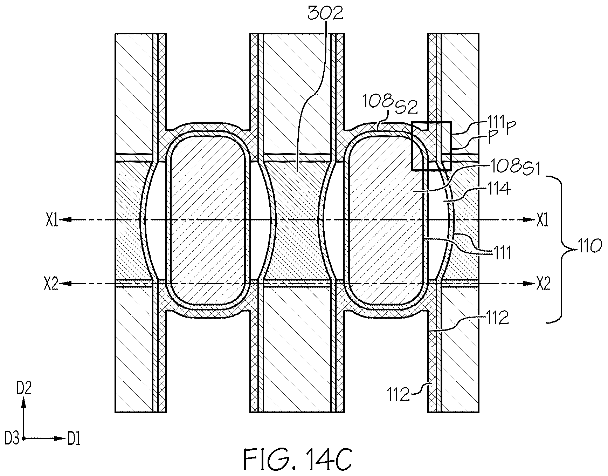

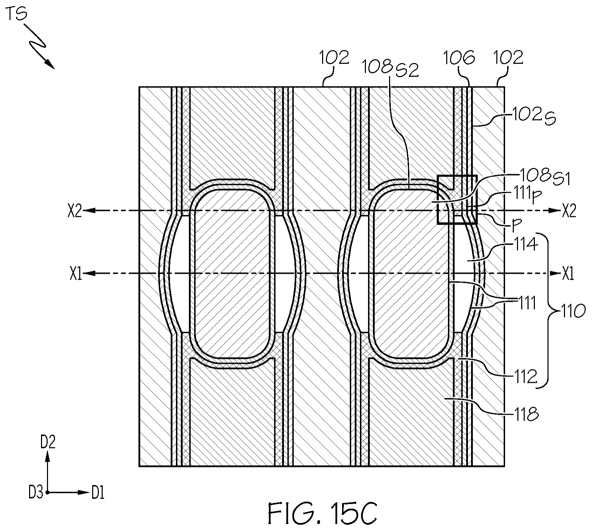

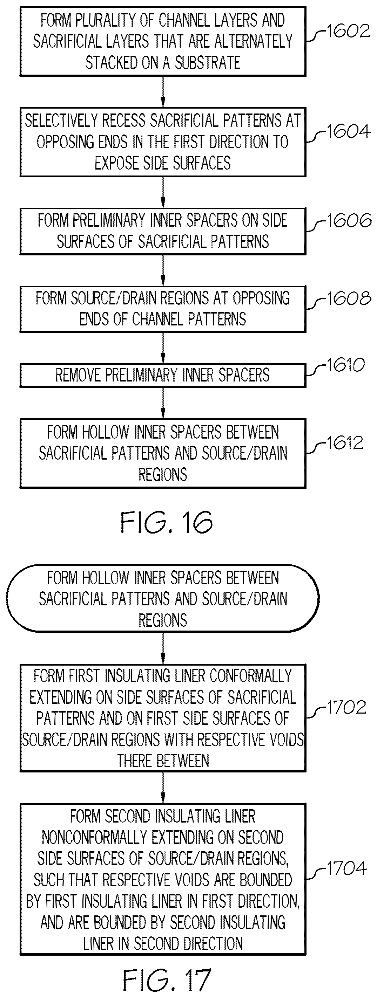

FIGS. 3, 4, 5, 6, 7, 8, 9, and 10, 11A, 12A, 13A, 14A, 14B, 15A, and 15B are schematic cross-sectional views illustrating methods of fabricating semiconductor integrated circuit devices according to some embodiments of the present disclosure. FIGS. 11B, 12B, and 13B correspond to FIG. 2A. FIGS. 14C and 15C correspond to FIG. 2A. FIGS. 16 and 17 are flowcharts illustrating methods of fabricating semiconductor integrated circuit devices according to some embodiments of the present disclosure. These methods are described below with reference to forming hollow inner spacers 110 including voids or air pockets 114 in a 3DSFET by way of example only, but may be used to similarly form hollow inner spacers 110 in other transistor configurations as well. Also, it will be understood that certain steps may not be performed in various embodiments, and the order of the steps for forming semiconductor integrated circuit devices according to embodiments of the present disclosure are not limited to the examples illustrated and described herein.

Referring to FIG. 3, the method may include forming a plurality of channel layers 104L and sacrificial layers 302L that are alternatingly stacked on the substrate 101. In some embodiments, the method may further include forming a middle sacrificial layer 318L that is between a pair of the sacrificial layers 302L (which may correspond to the first and second transistors 202a and 202b). The middle sacrificial layer 318L may have a greater thickness than the sacrificial layers 302L in some embodiments. The plurality of channel layers 104L may include semiconductor materials, such as silicon (Si), and the sacrificial layers 302L, 318L may include materials having etching selectivity with the materials of the channel layers 104L, such as silicon germanium (SiGe).

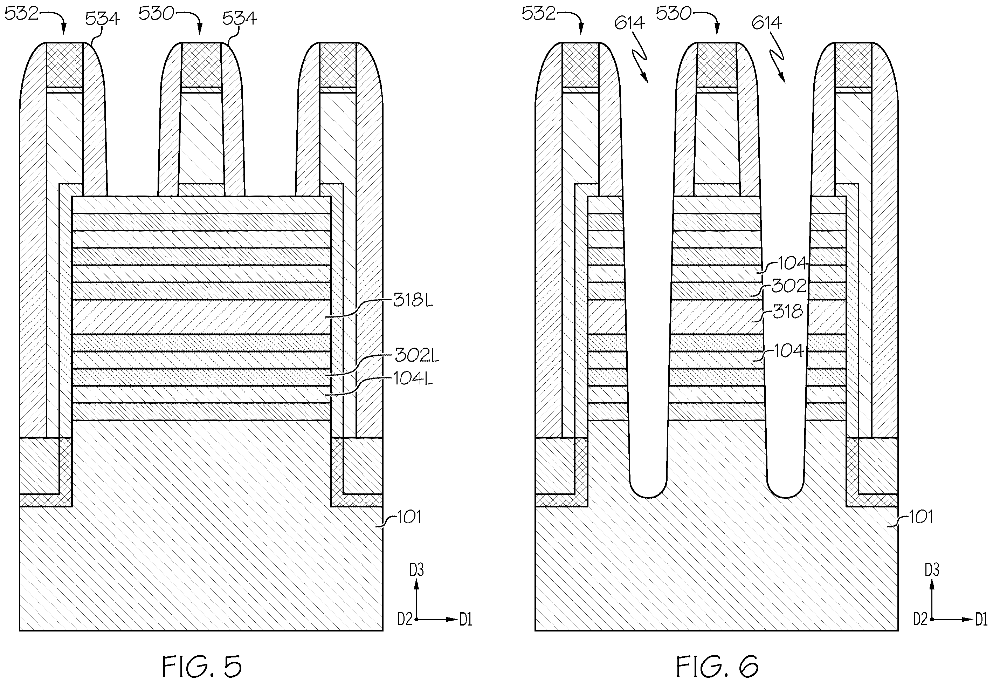

With reference to FIG. 4, the method may further include performing one or more etching processes on the channel layers 104L, the sacrificial layers 302L, the middle sacrificial layer 318L, and a portion of the substrate 101 to form recesses 410. The recesses 410 may extend into at least a portion of the substrate 101 at opposing sides of the channel layers 104L, the sacrificial layers 302L, the middle sacrificial layer 318L. The etching process(es) may include a wet etching process and/or a dry etching process (such as plasma-enhanced etching) and one or more mask patterns. In some embodiments, the etching process(es) include performing a dry or wet etching process and controlling parameters thereof to form sidewalls of the recesses 410 with a desired slope. As shown in FIG. 5, the method may further include forming mask structures 530, 532 (which may include one or more capping patterns or other protective patterns) and spacer structures 534 in the recesses 410 and on a portion of the remaining alternating stack.

Referring to FIG. 6 and the flowchart of FIG. 16, the method may include forming a plurality of channel patterns 104 and sacrificial gate patterns 302 that are alternatingly stacked on the substrate 101 (block 1602). For example, as shown in FIG. 6, an etching process may be performed using the structures 530, 532, and 534 as an etching mask to form recesses 614 that define the channel patterns 104 from the channel layers 104L, a middle sacrificial pattern 318 from the middle sacrificial layer 318L, and the sacrificial gate patterns 302 from the sacrificial layers 302L. The recesses 614 may extend into portions of the substrate 101 such that the substrate 101 may include recessed surfaces adjacent the opposing sides of the channel patterns 104 and sacrificial gate patterns 302.

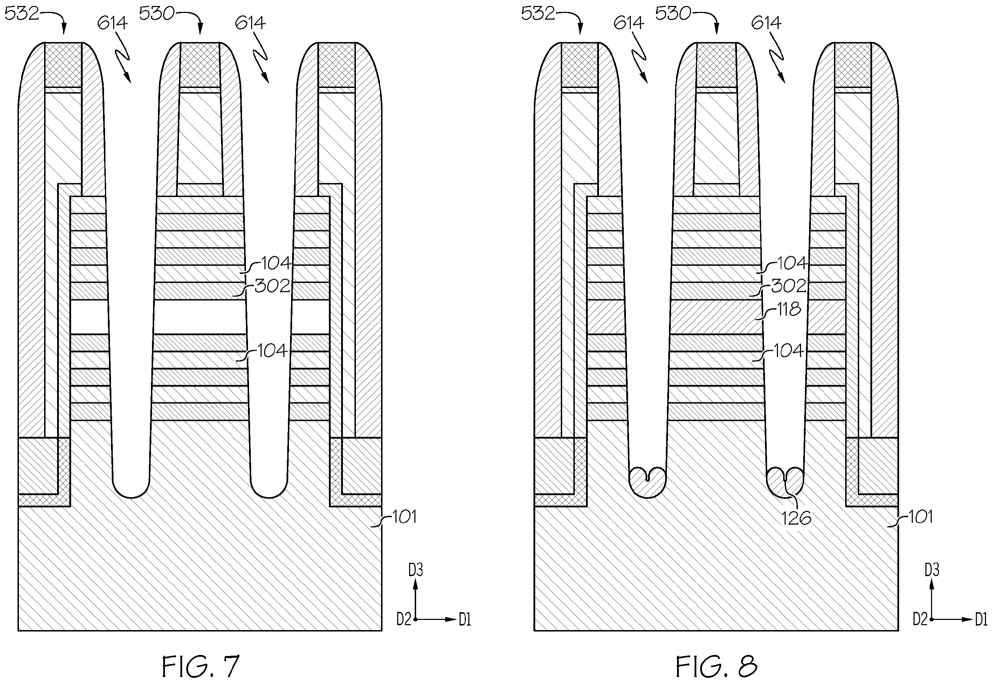

Referring to FIG. 7, a selective etching process is performed to remove the middle sacrificial pattern 318. As shown in FIG. 8, an isolation pattern 118 (also referred to as a middle dielectric isolation (MDI)) is formed by filling the region from which the middle sacrificial pattern 318 was removed with an insulating material, such as (but not limited to) SiN, SiOx, SiBCN, SiCN, SiON, SiOCN, or other insulating material. For example, the recesses 614 and the region from which middle sacrificial pattern 318 was removed may be filled with the MDI insulating material, which may be substantially removed from the recesses 614 to form the isolation pattern 118. Portions of the insulating material may remain at the bottom of the recesses 614 to form preliminary insulating regions 126'.

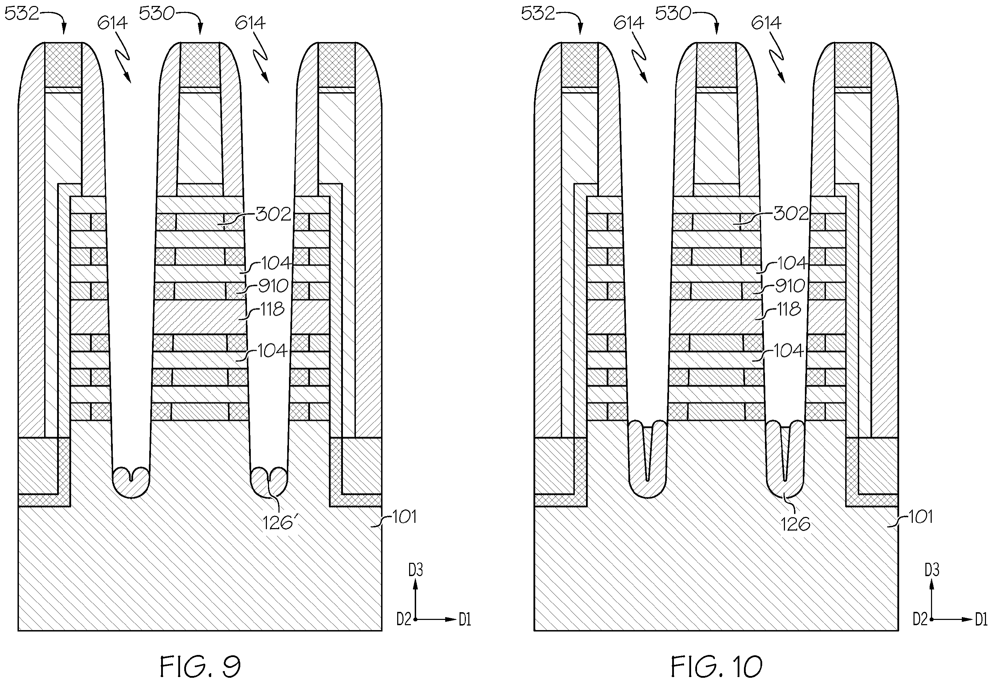

Referring to FIG. 9 and FIG. 16, edges of the sacrificial gate patterns 302 are selectively recessed at their opposing ends in the first direction D1 to expose side surfaces 302s thereof (block 1604), and preliminary inner spacers 910 are formed on the exposed side surfaces 302s at opposing ends of the sacrificial gate patterns 302 (block 1606). For example, a selective etch process may be used to recess the edges or side surfaces of the sacrificial gate patterns 302 that are exposed by the recesses 614, and an oxide or nitride layer may be formed on the recessed ends of the sacrificial gate patterns 302 to form the preliminary inner spacers 910. In some embodiments, the selective etch process may recess the edges or side surfaces of the sacrificial gate patterns 302 by a substantially similar amount, such that two or more of the preliminary inner spacers 910 may have substantially similar lengths in the first direction D1. In some embodiments, the selective etch process may recess the edges or side surfaces of the sacrificial gate patterns 302 by different amounts, such that two or more of the preliminary inner spacers 910 may have different lengths in the first direction D1. The preliminary inner spacers 910 may be formed of insulating or dielectric materials (for example, oxide or nitride materials), which may be the same as or different than (e.g., to provide etch selectivity with) the materials of the isolation patterns 118 and/or 122.

As shown in FIG. 10, one or more insulating patterns may be formed in or on the portions of the substrate 101 to at least partially fill the recesses 614, forming insulating regions 126. In some embodiments, the insulating regions 126 may be oxide-based (e.g., silicon oxide) patterns or nitride-based (e.g., silicon nitride) patterns, which may be formed by filling the recesses 614 with the oxide or nitride -based material, and etching the material to provide the insulating regions 126. The insulating regions 126 may be different than (e.g., to provide etch selectivity with) the materials of the preliminary inner spacers 910.

Referring to FIGS. 11A-11B (FIG. 11B corresponds to FIG. 2A) and FIG. 16, the method may further include forming source/drain regions 108 in the recesses 614 at opposing ends of the channel patterns 104 (block 1608). In particular, first (lower) source/drain regions 108a may be formed in the recesses 614 at opposing ends of the first channel patterns 104a. For example, the first source/drain regions 108a may be formed by selective epitaxial growth at the opposing sides of the first channel patterns 104a. In some embodiments, the first source/drain regions 108a may include a first semiconductor material that is the same as that of the first channel patterns 104a. For example, the first channel patterns 104a and the first source/drain regions 108a may be silicon (Si). After growing the first source/drain regions 108a, the method includes forming isolation patterns 122 on the first source/drain regions 108a. For example, an oxidation process (e.g., plasma oxidation or thermal oxidation) may be performed to oxidize upper surfaces of the first source/drain regions 108a to form the isolation patterns 122.

Still referring to FIGS. 11A-11B and FIG. 16, second (upper) source/drain regions 108b may be formed in the recesses 614 at opposing ends of the second channel patterns 104b. The isolation patterns 122 electrically separate the second source/drain regions 108b from the first source/drain regions 108a. For example, the second source/drain regions 108b may be formed by selective epitaxial growth at the opposing sides of the second channel patterns 104b. In some embodiments, the second source/drain regions 108b may include a second semiconductor material that is different from a first semiconductor material of the second channel patterns 104b. For example, the second channel patterns 104b may be silicon (Si), while the second source/drain regions 108b may be silicon germanium (SiGe). It will be understood that the first and second source/drain regions 108a and 108b may be formed in any order, and are not limited to the order described above. Responsive to formation of the first and second source/drain regions 108a and 108b, the preliminary inner spacers 910 are positioned between the side surfaces 302s of the sacrificial gate patterns 302 and first side surfaces 108s1 of the source/drain regions 108, which face one another in the first direction D1.

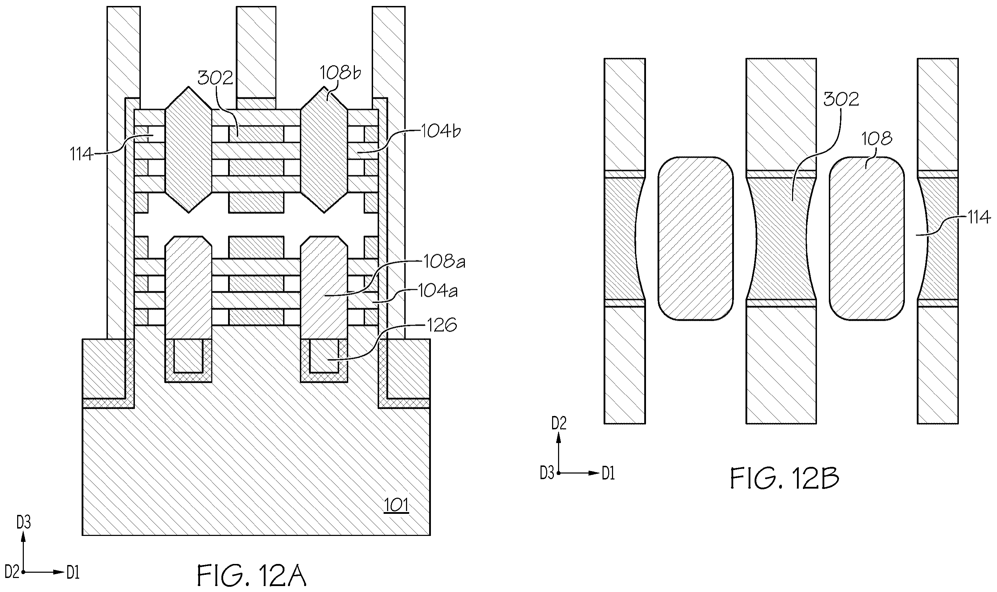

As shown in FIGS. 12A-12B (FIG. 12B corresponds to FIG. 2A.) and FIG. 16, the method may further include removing the preliminary inner spacers 910 between the side surfaces 302s of the sacrificial gate patterns 302 and the first side surfaces 108s1 of the source/drain regions 108 (block 1610), for example, using a selective etching process (such as a wet cleaning process). In some embodiments, the isolation patterns 118 and/or 122 (and/or the mask structures 530, 532, and spacer structures 534) may be formed of the same material(s) as the preliminary spacers 910, and thus, may likewise be removed along with the preliminary inner spacers 910 in the operations shown in FIGS. 12A-12B. As a result of removing the preliminary inner spacers 910, the side surfaces 302s of the sacrificial gate patterns 302 and the first side surfaces 108s1 of the source/drain regions 108, which face one another in the first direction D1, may be exposed. Second side surfaces 108s2 of the source/drain regions, which oppose one another in the second direction D2, may also be exposed.

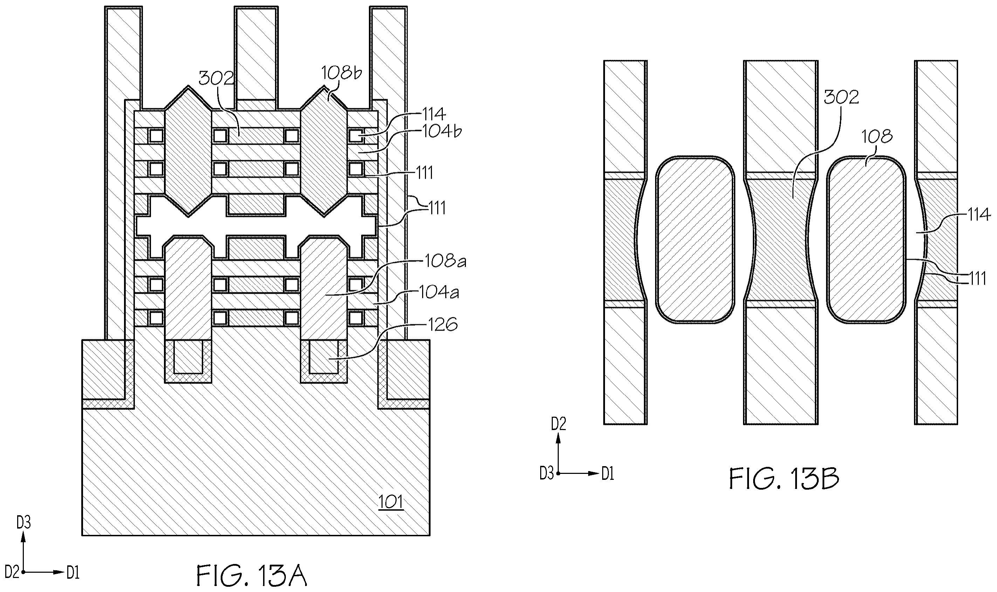

Referring to FIGS. 13A-13B, 14A-14C, 15A-15C, and 16, the method may further include forming hollow inner spacers 110 between the sacrificial gate patterns 302 and the source/drain regions 108 (block 1612). FIG. 17 is a flowchart illustrating example methods of forming the hollow inner spacers 110 at block 1612 of FIG. 16.

In particular, FIGS. 13A and 13B illustrate example methods for forming a conformal first insulating liner 111 of the hollow inner spacers 110. As shown in FIGS. 13A-13B (FIG. 13B corresponds to FIG. 2A) and FIG. 17, a first insulating liner 111 is formed on the side surfaces 302s of the sacrificial gate patterns 302 as well as on the first side surfaces 108s1 of the source/drain regions 108, thereby providing respective voids 114 between the side surfaces 302s of the sacrificial gate patterns 302 and the first side surfaces 108s1 of the source/drain regions 108 in the first direction D1 (block 1702).

The first insulating liner 111 is formed in a conformal manner on the side surfaces 302s of the sacrificial gate patterns 302 and the first side surfaces 108s1 of the source/drain regions 108. For example, the first insulating liner 111 may be deposited (e.g., by performing a chemical vapor deposition (CVD) process, a physical vapor deposition (PVD) process, an atomic layer deposition (ALD) process, or the like) so as to conformally extend on portions or surfaces of the channel patterns 104, sacrificial gate patterns 302, and source/drain regions 108 that are exposed (e.g., in the recesses 614) by removal of the preliminary inner spacers 910 at block 1610.

The first insulating liner 111 may include an insulating or dielectric material (e.g., silicon nitride (SiN) and/or low-k materials having a dielectric constant lower than that of silicon oxide (SiO)). In some embodiments, first insulating liner 111 may be a relatively thin layer, that is, having a thickness T1 that is sufficient to extend along the side surfaces 302s of the sacrificial gate patterns 302 and along the first side surfaces 108s1 of the source/drain regions 108 without completely filling the spaces therebetween, such that respective voids 114 are bounded by the first insulating liner 111 in the first direction D1. The first insulating liner 111 may also be formed to conformally extend on second side surfaces 108s2 of the source/drain regions 108, which oppose one another in a second direction D2 that intersects the first direction D1.

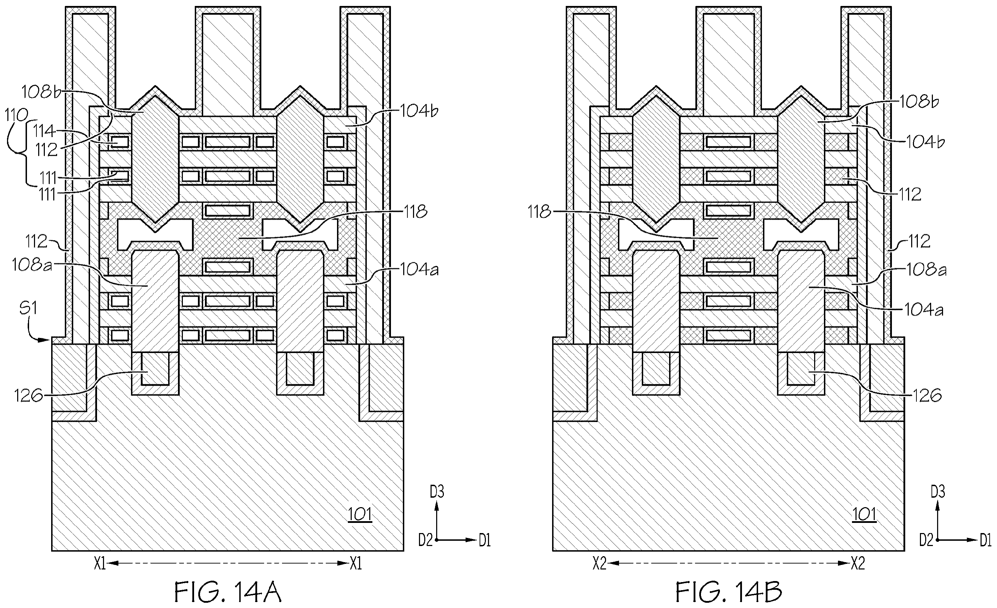

FIGS. 14A and 14B illustrate example methods for forming a non-conformal second insulating liner 112 of the hollow inner spacers 110. FIG. 14C corresponds to FIG. 2A, while the cross-sections of FIGS. 14A and 14B are taken along line X1-X1 and X2-X2 of FIG. 14C.

As shown in FIGS. 14A-14C and FIG. 17, a second insulating liner 112 is formed to non-conformally extend on the second side surfaces 108s2 of the source/drain regions 108 (block 1704). For example, the second insulating liner 112 may be deposited (e.g., by performing a chemical vapor deposition (CVD) process, a physical vapor deposition (PVD) process, an atomic layer deposition (ALD) process, or the like) so as to non-conformally extend on portions or surfaces of the channel patterns 104, sacrificial gate patterns 302, and source/drain regions 108 having the first insulating liner 111 thereon, so as to seal or at least partially surround the channel patterns 104, sacrificial gate patterns 302, and source/drain regions 108.

In some embodiments, the second insulating liner 112 may be formed using a liner overhang technique, so as to extend at least partially between respective portions 111p of the first insulating liner 111 on the side surfaces 302s of the sacrificial gate patterns 302 and the first side surfaces 108s1 of the source/drain regions 108, collectively enclosing the respective voids 114. That is, the second insulating liner 112, together with the first insulating liner 111, collectively form hollow inner spacers 110 that enclose the respective voids 114.

The second insulating liner 112 may include an insulating or dielectric material (e.g., silicon nitride (SiN) and/or low-k materials having a dielectric constant lower than that of silicon oxide (SiO)), which may be the same as or different from the material of the first insulating liner 111. For example, the second insulating liner 112 may be formed of a second material that may be deposited with less conformality than a first material of the first insulating liner 111. In some embodiments, the second insulating liner 112 may be a relatively thick layer in comparison to the thickness T1 of the first insulating liner 111. The second insulating liner 112 may have a thickness T2 that is sufficient to fill gaps between portions 111p of the first insulating liner 111 between the side surfaces 302s of the sacrificial gate patterns 302 and the first side surfaces 108s1 of the source/drain regions 108, such that respective voids 114 are bounded by the second insulating liner 112 in the second direction D2. That is, responsive to depositing the second insulating liner 112, air pockets 114 (i.e., cavities or voids including air) may be formed within the hollow inner spacers 110.

Accordingly, an integrated circuit device 100 may have hollow inner spacers 110 including air pockets or voids 114, which may have desired profiles that can reduce parasitic capacitance in the integrated circuit device 100. In particular, as shown in FIGS. 14A, 14B, and 14C, the hollow inner spacers 110 include first portions 111 having a first thickness T1 with the respective voids 114 therebetween in a first cross-section X1-X1 along the first direction D1, and second portions 112 having a second thickness T2 that is free of the respective voids 114 therebetween in a second cross-section X2-X2 along the first direction D1. That is, the hollow inner spacers 110 may have different cross-sectional profiles at central portions (which may be hollow) and edge portions (which may be filled by the liners 111 and/or 112). In some embodiments, the first and second insulating liners 111 and 112 of the hollow inner spacers 110 may both be formed of low-k materials (i.e., respective materials having a dielectric constant that is less than or equal to that of silicon nitride) so as to further reduce capacitive effects.

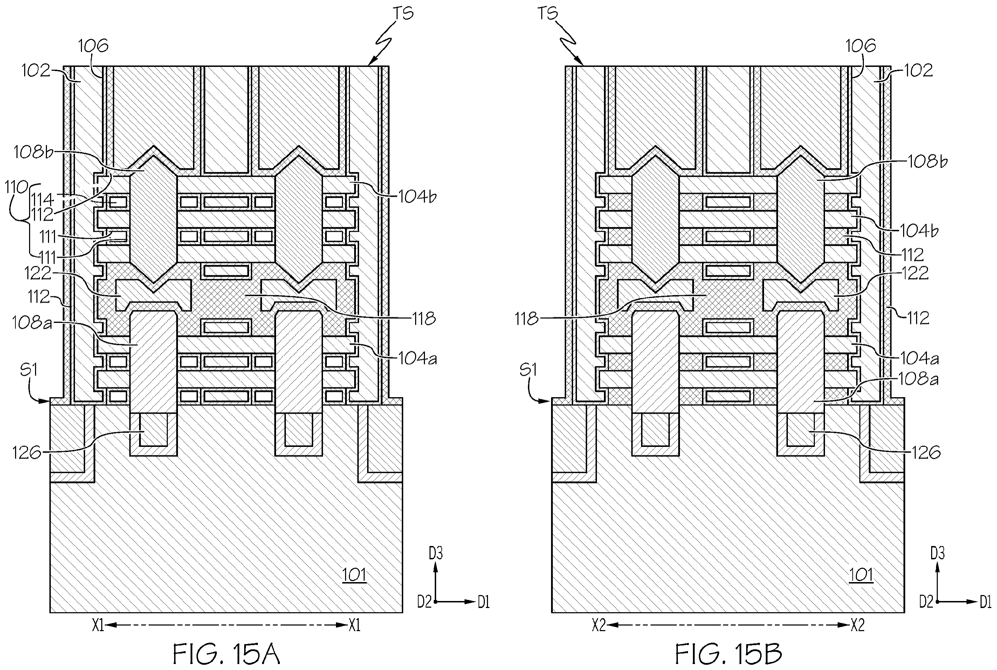

FIGS. 15A and 15B illustrate example methods for forming a replacement metal gate (RMG). FIG. 15C corresponds to FIG. 2A, while the cross-sections of FIGS. 15A and 15B are taken along line X1-X1 and X2-X2 of FIG. 15C.

As shown in FIGS. 15A to 15C, the replacement metal gate process is performed in which the sacrificial gate patterns 302 are selectively removed, and gate patterns 102 are formed to replace the sacrificial gate patterns 302. In particular, after forming the insulating liners 111 and 112 as described above, the sacrificial gate patterns 302 between the respective voids 114 may be selectively etched, and the gate patterns 102 may be formed in the areas from which the sacrificial gate patterns 302 were removed. The first insulating liner 111 thus conformally extends along side surfaces 102s of the gate patterns 102 and along the first side surfaces 108s1 of the source/drain regions 108, with the respective voids 114 therebetween in the first direction D1, while the second insulating liner 112 non-conformally extends along the second side surfaces 108s2 of the source/drain regions 108 and at least partially between respective portions 111p of the first insulating liner 111 on the side surfaces 102s of the gate patterns 102 and the first side surfaces 108s1 of the source/drain regions 108. That is, the method may further include replacing the sacrificial gate patterns 302 with the conductive gate patterns 102 between first and second source/drain regions 108a, 108b, with the hollow inner spacers 110 therebetween, to thereby form the first and second transistors 202a, 202b of the integrated circuit device 100 shown in FIGS. 2B-2C.

Accordingly, the methods illustrated in FIGS. 3 to 17 form channel patterns 104 that extend between source/drain regions 108 in a first direction D1 and are alternately stacked with sacrificial gate patterns 302. The sacrificial gate patterns 302 are selectively recessed at opposing ends thereof in the first direction to expose side surfaces 302s, preliminary inner spacers 910 are formed on the side surfaces 302s of the sacrificial gate patterns 302, and source/drain regions 108 are formed at the opposing ends of the channel patterns 104 such that the preliminary inner spacers 910 reside between the side surfaces 302s of the sacrificial gate patterns 302 and the first side surfaces 108s1 of the source/drain regions 108 that face one another in the first direction D1. An etching process is performed to remove the preliminary inner spacers 910 between the sacrificial gate patterns 302 and the source/drain regions 108. Hollow inner spacers 110 are formed between the sacrificial gate patterns 302 and the source/drain regions 108 by forming a first insulating liner 111 that conformally extends on side surfaces 302s of the sacrificial gate patterns 302 and first side surfaces 108s1 of the source/drain regions 108, thereby providing voids 114 therebetween in the first direction, and forming a second insulating liner 112 that non-conformally extends on the second side surfaces 108s2 of the source/drain regions 108, which oppose one another in a second direction D2 intersecting the first direction D1. The respective voids 114 are thereby bounded by the first insulating liner 111 in the first direction D1 and by the second insulating liner 112 in the second direction D2.

Embodiments of the present disclosure may thereby provide methods for fabricating 3D stacked transistor structures (e.g., 3DSFETs) with improved device performance and reliability by forming air pockets within the inner spacers of the 3DSFETs, thereby reducing parasitic capacitance by using air and providing increased flexibility for a desired profile of the inner spacers. Further, advantages of structures, features, or operations disclosed herein may include, for example, improved device performance and reliability for integrated circuit devices (e.g., 3DSFETs) by depositing liners (e.g., a first conformal insulating liner 111 and a second non-conformal insulating liner 112) that include low-k materials, thereby reducing parasitic capacitance. However, it will be understood that embodiments of the present disclosure are not limited to the above described advantages.

Unless otherwise defined, all terms used herein have the same meaning as commonly understood by one of ordinary skill in the art. Further, all terms should be interpreted as having a meaning that is consistent with their meaning in the context of the relevant art and this disclosure and will not be interpreted in an idealized or overly formal sense unless expressly so defined herein. For example, as noted herein, an "insulating" layer or liner may include dielectric materials (which may be polarizable by an applied electric field).

In the description above, each example embodiment is described with reference to regions of particular conductivity types. It will be appreciated that opposite conductivity type devices may be formed by simply reversing the conductivity of the n-type and p-type layers in each of the above embodiments. Thus, it will be appreciated that the present invention covers both n-channel and p-channel devices for each different device structure.

The terminology used herein is for the purpose of describing particular embodiments only and is not intended to be limiting of embodiments. The singular forms "a," "an," and "the" are intended to include the plural forms as well, unless the context clearly indicates otherwise. The terms "comprises," "comprising," "includes" and/or "including" specify the presence of stated features, steps, operations, elements and/or components, but do not preclude the presence or addition of one or more other features, steps, operations, elements, components and/or groups thereof.

It will be understood that, although the terms "first," "second," etc. are used throughout this specification to describe various elements, these elements should not be limited by these terms. These terms are only used to distinguish one element from another. For example, a first element could be termed a second element, and, similarly, a second element could be termed a first element, without departing from the scope of the present invention. The term "and/or" includes any and all combinations of one or more of the associated listed items.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Spatially relative terms such as "below" or "above" or "upper" or "lower" or "top" or "bottom" may be used herein to describe a relationship of one element, layer or region to another element, layer or region based on a frame of reference (e.g., a substrate), as illustrated in the figures. It will be understood that these terms are intended to encompass different orientations of the device in addition to the orientation depicted in the figures.

Example embodiments are described herein with reference to the accompanying drawings, which may include cross-section illustrations that are schematic illustrations of idealized embodiments (and intermediate structures). Many different forms and embodiments are possible without deviating from the teachings of this disclosure. Accordingly, the disclosure should not be construed as limited to the example embodiments set forth herein. As such, it will be understood by those of ordinary skill in the art that various changes in form and details may be made therein without departing from the spirit and scope as defined herein. In the drawings, the sizes and relative sizes of layers and regions may be exaggerated for clarity. Additionally, variations from the shapes of the illustrations as a result, for example, of manufacturing techniques and/or tolerances, are to be expected.

Embodiments of the invention are also described with reference to a fabrication operations and flowchart diagrams. It will be appreciated that the steps shown in the fabrication operations and flowchart diagrams need not be performed in the order shown.

## Claims

1. An integrated circuit device (100) comprising:
a transistor structure (TS) comprising:
one or more channel patterns (104) that extend between source/drain regions (108) in a first direction (D1) and are alternately stacked with one or more gate patterns (102); and
hollow inner spacers (110) between the one or more gate patterns (102) and the source/drain regions (108), wherein the hollow inner spacers (110) comprise:
respective voids (114) between side surfaces of the one or more gate patterns (102) and first side surfaces of the source/drain regions (108) in the first direction (D1); and
a first liner (111) on the side surfaces of the one or more gate patterns (102) and on the first side surfaces of the source/drain regions (108).

2. The integrated circuit device of Claim 1, wherein the first liner (111) conformally extends on the side surfaces of the one or more gate patterns (102) and the first side surfaces of the source/drain regions (108), and the respective voids (114) are bounded by the first liner (111) in the first direction (D1).

3. The integrated circuit device of Claim 2, wherein the hollow inner spacers (110) further comprise:
a second liner (112) on second side surfaces of the source/drain regions (108), which oppose one another in a second direction (D2) that intersects the first direction (D1),
wherein the second liner (112) and the first liner (111) collectively enclose the respective voids (114).

4. The integrated circuit device of Claim 3, wherein the second liner (112) non-conformally extends on the second side surfaces of the source/drain regions (108), and the respective voids (114) are bounded by the second liner (112) in the second direction (D2).

5. The integrated circuit device of Claim 3 or 4, wherein the second liner (112) extends at least partially between respective portions of the first liner (111) on the side surfaces of the one or more gate patterns (102) and the first side surfaces of the source/drain regions (108).

6. The integrated circuit device of any one of Claims 3 to 5, wherein the hollow inner spacers (110) comprise first portions having a first thickness with the respective voids (114) therebetween in a first cross-section along the first direction (D1), and second portions having a second thickness that is free of the respective voids (114) therebetween in a second cross-section along the first direction (D1).

7. The integrated circuit device of any one of Claims 3 to 6, wherein the first liner (111) or the second liner (112) comprise respective materials having a dielectric constant that is less than or equal to that of silicon nitride.

8. The integrated circuit device of any one of Claims 1 to 7, wherein:
the one or more channel patterns (104) comprise lower and upper nanosheets (104a , 104b) of first and second transistors (202a, 202b), respectively;
the one or more gate patterns (102) comprise lower gate and upper gate patterns (102a, 102b) of the first and second transistors (202a, 202b), respectively; and
the source/drain regions (108) comprise lower and upper source/drain regions (108a, 108b) of the first and second transistors (202a, 202b), respectively.

9. The integrated circuit device of Claim 8, wherein the lower source/drain regions (108a) are of a first conductivity type, and the upper source/drain regions (108b) are of a second conductivity type that is opposite to the first conductivity type.

10. A method of fabricating an integrated circuit device, the method comprising:
forming a plurality of channel patterns (104) and sacrificial gate patterns (302) that extend in a first direction (D1) and are alternately stacked on a substrate (101);
selectively recessing the sacrificial gate patterns (302) at opposing ends thereof in the first direction (D1) to expose side surfaces thereof;
forming preliminary inner spacers (910) on the side surfaces of the sacrificial gate patterns (302);
forming source/drain regions (108) at opposing ends of the channel patterns (104),
wherein the preliminary inner spacers (910) are between the side surfaces of the sacrificial gate patterns (302) and first side surfaces of the source/drain regions (108), which face one another in the first direction (D1);
performing an etching process to remove the preliminary inner spacers (910); and
forming a first liner (111) on the side surfaces of the sacrificial gate patterns (302) and on the first side surfaces of the source/drain regions (108) with respective voids (114) therebetween in the first direction (D1).

11. The method of Claim 10, wherein the first liner (111) conformally extends on the side surfaces of the sacrificial gate patterns (302) and the first side surfaces of the source/drain regions (108), and the respective voids (114) are bounded by the first liner (111) in the first direction (D1).

12. The method of Claim 11, further comprising:
forming a second liner (112) on second side surfaces of the source/drain regions (108), which oppose one another in a second direction (D2) that intersects the first direction (D1),
wherein the second liner (112) and the first liner (111) collectively provide hollow inner spacers (110) that enclose the respective voids (114).

13. The method of Claim 12, wherein the second liner (112) non-conformally extends on the second side surfaces of the source/drain regions (108), and the respective voids (114) are bounded by the second liner (112) in the second direction (D2).

14. The method of Claim 12 or 13, wherein the second liner (112) extends at least partially between respective portions of the first liner (111) on the side surfaces of the sacrificial gate patterns (302) and the first side surfaces of the source/drain regions (108).

15. The method of any one of Claims 12 to 14, wherein the hollow inner spacers (110) comprise first portions having a first thickness with the respective voids (114) therebetween in a first cross-section along the first direction (D1), and second portions having a second thickness that is free of the respective voids (114) therebetween in a second cross-section along the first direction (D1).
